# EUROPÄISCHE PATENTANMELDUNG

(11) **EP 1 818 679 A1**
(43) Veröffentlichungstag der Anmeldung: **15.08.2007**
(21) Anmeldenummer: 07002874.1
(22) Anmeldetag: 10.02.2007
(51) Int. Cl.: G01R 33/30

(54) **Probenhalter zum Fixieren und Transportieren eines Probengläschens innerhalb einer NMR-Anordnung sowie automatische Bestückungsvorrichtung für den automatisierten Wechsel von NMR-Probengläschen und Betriebsverfahren**

(30) Priorität: 13.02.2006 DE 102006006705
(71) Anmelder: Bruker BioSpin AG, 8117 Fällanden (CH)
(72) Erfinder: Himmelsbach, Kurt, 8320 Fehraltdorf (CH); Sestito, Franco, 8408 Winterthur (CH)
(74) Vertreter: Kohler Schmid Möbus

(57) **Zusammenfassung**

Ein Probenhalter zum Fixieren und Transportieren eines Probengläschens (1) innerhalb einer Kernspinresonanz(=NMR)-Anordnung mit einem Außenmantel (4) und einem innerhalb des Außenmantels (4) angeordneten, entlang seiner Achse verlaufenden durchgehenden Hohlraum zum Aufnehmen des Probengläschens, ist dadurch gekennzeichnet, dass eine lösbare Klemmvorrichtung und ein Schaltelement (6) innerhalb des Hohlraum vorgesehen sind, wobei die Klemmvorrichtung im aktivierten Zustand ein in den Probenhalter eingeführtes Probengläschen (1) fixiert, dass das Schaltelement (6) von außen betätigbar ist, und dass die Klemmvorrichtung mittels des Schaltelements (6) deaktivierbar ist, so dass im deaktivierten Zustand keine Fixierung eines in den Probenhalter eingeführten Probengläschens (1) erfolgt. Ein derartiger Probenhalter kann zur Realisierung einer automatischen Bestückungsvorrichtung für den Wechsel von NMR-Probengläschen dienen, die sehr kompakt aufgebaut ist und Platz sparend montiert werden kann.

## Beschreibung

Die Erfindung betrifft einen Probenhalter zum Fixieren und Transportieren eines Probengläschens innerhalb einer NMR-Anordnung mit einem Außenmantel und einem innerhalb des Außenmantels angeordneten, entlang seiner Achse verlaufenden durchgehenden Hohlraum zum Aufnehmen des Probengläschens sowie eine automatische Bestückungsvorrichtung mit einem erfindungsgemäßen Probenhalter für den automatisierten Wechsel von NMR-Probengläschen und deren Betriebsverfahren.

Ein derartiger Probenhalter ist bereits bekannt aus US 6,686,740 B2.

In der NMR-Spektroskopie und speziell bei ihren industriellen Anwendungen kommt es oft vor, dass größere Mengen von NMR-Proben automatisch, d.h. ohne manuelle Hilfe gemessen werden sollen, um damit Personal einzusparen und die Auslastung der sehr teuren NMR-Spektrometer zu verbessern.

Solche Automaten umfassen im Allgemeinen einen Probenbehälter, der die zu messenden NMR-Probengläschen mit den darin enthaltenen Messsubstanzen enthält, einen Transport-Automaten, der den bereits mit einem Probengläschen bestückte Probenhalter erfasst und bis zum oberen Ende der Raumtemperaturbohrung (= RT-Bohrung) des NMR-Magneten befördert, oder einen Transport-Roboter, der das Probengläschen aus einem Probenbehälter entnimmt und zu einem Bestückungsautomaten führt, der das Probengläschen in einen Probenhalter steckt, wobei anschließend der Transport-Roboter den Probenhalter samt Probengläschen zum oberen Ende der RT-Bohrung befördert. Dort wird der Probenhalter samt Probengläschen von einem Luftkissenautomaten übernommen und auf einem Luftkissen vom oberen Ende der RT-Bohrung bis zum Messraum im Innern der RT-Bohrung und nach erfolgter Messung wieder zurück an das obere Ende der RT-Bohrung getragen.

Der Luftkissenautomat arbeitet eng zusammen mit einer "Docking-Vorrichtung (= Dock-Unit), welche unter anderem den Probenkopf aufnehmen und befestigen kann. Die Dock-Unit befindet sich innerhalb der RT-Bohrung und erstreckt sich über deren ganzen Länge. Sie enthält das RT-Shimsystem sowie evtl. Gradientenspulen und besitzt am unteren Ende eine zylinderförmige Öffnung, in die der gewünschte Probenkopf eingeführt und befestigt werden kann. Im oberen Teil der Dock-Unit ist ein zylindrisches Rohr mit einer am oberen Ende nach außen führenden Öffnung vorhanden, durch die das Probengläschen hinunter bis zum Messraum befördert werden kann. Unten an der Dock-Unit wird Druckluft zugeführt, die einerseits zur Rotation des Probengläschens mit Hilfe einer Luftturbine dient, anderseits aber einen Luftstrom für den Luftkissenautomaten erzeugt. Dieser Luftstrom fließt entlang des Rohrs, der zur zylinderförmigen Öffnung am oberen Ende der Dock-Unit führt, nach oben und entweicht dort nach außen.

Wichtig für die korrekte Funktionsweise des Luftkissenautomaten ist die maximale äußere Abmessung des Probenhalters, der mit wenig Spiel in die obere Öffnung der Dock-Unit passen muss, so dass nicht zuviel Luft seitlich entweichen kann. Dadurch entsteht unterhalb des Probenhalters ein Luftkissen, auf dem der Probenhalter samt Probengläschen aufliegen und durch Verkleinern oder Vergrößern des Luftdruckes nach unten resp. nach oben gleiten kann.

Für jeden Durchmesser des Probengläschens gibt es einen dazugehörenden Probenhalter, der so konstruiert ist, dass unabhängig vom Durchmesser des Probengläschens, seine Außenabmessungen vorzugsweise die gleichen sind.

Als Probenhalter werden heute sowohl so genannte "Spinner" wie auch "Shuttles" verwendet. Beim Spinner steckt das Probengläschen fest eingeklemmt im Spinner, der seinerseits so geformt ist, dass er mit wenig Spiel in die obere Öffnung der Dock-Unit eingeführt werden kann, zudem aber auch genau passend auf die Luftturbine der Dock-Unit zu liegen kommt. Dadurch wird das Probengläschen richtig positioniert und zentriert. Falls erwünscht, kann das Probengläschen samt Spinner mit Hilfe der Luftturbine in Rotation gebracht werden, um Inhomogenitäten des statischen Magnetfeldes B₀ auszumitteln. Voraussetzung dazu ist jedoch, dass der Spinner und das Probengläschen eine sehr hohe axiale Symmetrie aufweisen, und dass deren Symmetrieachsen genau aufeinander liegen, so dass eine Rotation um eine stabil bleibende Rotationsachse resultiert.

Bei der aus US 6,686,740 B2 bekannten Vorrichtung steckt das Probengläschen, dessen Durchmesser vorzugsweise im Bereich von 1 bis 3 mm liegt, lose im Shuttle, wobei eine Hülse, welche die oben liegende Öffnung des Probengläschen verschließt, auf einen Absatz innerhalb des Shuttles zu liegen kommt. Dadurch kann das Probengläschen nicht aus dem Shuttle nach unten fallen. Die lose Positionierung des Probengläschens im Shuttle erlaubt eine seitliche sowie eine nach oben gerichtete axiale Beweglichkeit, wodurch die Gefahr eines Zerbrechens des Probengläschens bei dessen Transport in den Messraum erheblich vermindert wird. Der Außendurchmesser des Shuttles ist ebenfalls so dimensioniert, dass er mit wenig Spiel in die obere Öffnung der Dock-Unit eingeführt werden kann. Eine Rotation des Probengläschens ist in diesem Fall nicht vorgesehen. Die äußere Form des Shuttles wird vorzugsweise genau gleich wie die des Spinners gewählt, so dass beide Probenhalter, Spinner sowie Shuttle, passend auf der Luftturbine der Dock-Unit liegen können.

Die Hülse oben am Probengläschen hat einerseits die Aufgabe, die Messsubstanz im Innern des Probengläschens hermetisch gegen außen abzuschließen, um eine Verflüchtigung der Messsubstanz zu vermeiden, anderseits soll sie auch ermöglichen, einen Identifikationscode (z.B. DOT-Matrix-Code) auf der oberen Fläche der Hülse anzubringen. Ein solcher Identifikationscode ist sehr zweckmäßig für den automatisierten Probenwechsel, denn er definiert unter anderem die bei der Messung vorzunehmenden Einstellungen der NMR-Parameter.

Bei einigen der heute bekannten Automaten zum Wechseln des NMR- Probengläschens wird jedes zu messende Probengläschen zuerst manuell mit je einem Probenhalter (entweder Spinner oder Shuttle) bestückt und dann in den Probenbehälter gesteckt. Ein Transportautomat befördert anschließend einen der Probenhalter samt Probengläschen aus dem Probenbehälter und führt ihn zum oberen Ausgang der Dock-Unit, wo er dann vom Luftkissenautomaten in den Messbereich befördert wird.

Solche Automaten haben aber schwerwiegende Nachteile:

Da die Einheit bestehend aus Probenhalter samt Probengläschen bis zu 25 mal größere Lagerfläche beansprucht, als das Probengläschen alleine, müssen die Probenbehälter entweder sehr groß dimensioniert oder mit weniger Einheiten bestückt werden, was ein großer Nachteil ist. Ferner benötigt jedes Probengläschen einen eigenen Probenhalter, so dass eine große Anzahl "Spinner" oder "Shuttles" zur Verfügung stehen müssen, was einen relativ hohen Kostenfaktor bedeutet.

Darüber hinaus bedeutet die manuelle Bestückung des Probenhalters mit einem Probengläschen Zeitverlust und zusätzliche Belastung des Personals, was für einen optimalen automatisierten Betrieb vermieden werden sollte.

Um diese Nachteile zu vermeiden, sind heute Automaten bekannt, welche sowohl die automatische Bestückung des Probenhalters mit einem Probengläschens wie auch die Übergabe des Probenhalters samt Probengläschen an den Luftkissenautomaten übernehmen. Die Bestückung erfolgt mit einem gesteuerten Bestückungs-Roboter. Dieser ergreift ein einzelnes Probengläschen aus dem Probenbehälter, der ausschließlich Probengläschen enthält, und steckt dieses von oben in den Probenhalter hinein. Wenn der Probenhalter ein konventioneller Spinner ist, muss das Probengläschen normalerweise durch einen Gummiring oder eine andere passive Spannvorrichtung gestoßen werden, der sich im Innern des Spinners befindet, und der die Aufgabe hat, das Probengläschen festzuhalten. Dabei entstehen erhebliche Reibungskräfte zwischen Probengläschen und Spannvorrichtung. Anschließend übergibt der Bestückungs-Roboter den Probenhalter samt Probengläschen an den Transportautomaten, der diese Einheit auf das Luftkissen oberhalb der RT-Bohrung des Magneten legt und das weitere Vorgehen dem Luftkissenautomaten überlässt.

Nach erfolgter Messung wird der Probenhalter samt Probengläschen mit dem Luftkissenautomaten nach oben befördert, dort vom Transportautomaten übernommen und durch diesen wieder zum Bestückungs-Roboter verschoben, der das Probengläschen wieder aus dem Probenhalter entfernen muss. Dieser Vorgang ist im Falle eines konventionellen Spinners wiederum mit erheblichen Reibungskräften verbunden. Wenn der Bestückungsroboter diesen Vorgang durch eine feste Umklammerung des oberen Endes des Probengläschens und eines anschließenden Ziehens des Probengläschens aus dem Spinner versuchen würde, könnte das Probengläschen leicht zerbrechen. Deshalb muss der Bestückungs-Roboter Zugang zum unteren Ende des Probengläschens haben, um von dort aus mit einem Stoßvorgang nach oben das Probengläschen wieder aus dem Gummiring oder der passiven Spannvorrichtung zu schieben. Anschließend muss der Roboter seine Position von unten wieder nach oben ändern, dort das lose Probengläschen ergreifen, und dieses wieder zurück zum Probenbehälter befördern.

Beim gerade beschriebenen Automaten ist es somit wichtig, dass das Einsetzten und Entfernen des Probengläschens jeweils durch einen Stoßvorgang erfolgt, denn nur so kann die Gefahr, dass das Probengläschen zerbricht, oder der Greifer vom Röhrchen abrutscht minimiert werden.

Bei diesen Automaten treten folgende Nachteile auf:

Der Bestückungs-Roboter muss beim Herausnehmen des Probengläschens aus dem Spinner einen Zugang zum unteren Ende des Probengläschens haben, damit das Probengläschen durch einen Stoßvorgang von unten her aus der Umklammerung des Spinners gelöst werden kann.

Des Weiteren benötigt der Automat zusätzlich zum Bestückungsroboter, der zugleich auch für den Transport des Probengläschens vom Probenbehälter zur Bestückungsvorrichtung verantwortlich ist, noch einen Transportautomaten - im Ganzen also zwei automatisch arbeitende Systeme.

Darüber hinaus beansprucht der gesamte Automat viel Platz und braucht ein eigenes, mitunter sehr großes Montagegestell.

Zudem benutzen alle diese Automaten als Probenhalter konventionelle Spinner, wie sie im manuellen Betrieb benutzt werden, oder Spinner, die in ihrer Funktionsweise, den konventionellen Spinnern ähnlich sind, was zu folgenden weiteren Nachteilen führt:

Die Kraft, die der Automat aufwenden muss, um das Probenröhrchen in einen solchen Spinner einzuführen, ist relativ groß. Diese Kraft ist eine Folge des hohen Anpressdruckes zwischen Spinner und Probengläschen, der erforderlich ist, um die hohe Präzision zu erreichen, mit der die Symmetrieachsen des Probenröhrchens und des Spinners übereinstimmen müssen, um eine saubere Rotation zu erreichen. Der große Anpressdruck erzeugt jedoch große Reibungskräfte zwischen Spinner und Probengläschen und führt zu Abnutzungserscheinungen am Spinner, insbesondere beim zweiten beschriebenen Automaten, der einen Bestückungs-Roboter besitzt und einen einzigen Spinner für alle Probengläschen desselben Durchmessers benötigt.

Aufgabe der vorliegenden Erfindung ist es, einen Probenhalter vorzuschlagen, mit dem die oben genannten Nachteile vermieden werden können, sowie die Realisierung einer automatischen Bestückungsvorrichtung für den Wechsel von NMR-Probengläschen, die sehr kompakt aufgebaut ist und Platz sparend montiert werden kann.

Diese Aufgabe wird erfindungsgemäß durch einen Probenhalter gelöst, bei dem eine lösbare Klemmvorrichtung und ein Schaltelement innerhalb des Hohlraum vorgesehen sind, wobei die Klemmvorrichtung im aktivierten Zustand ein in den Probenhalter eingeführtes Probengläschen fixiert, bei dem das Schaltelement von außen betätigbar ist, und bei dem die Klemmvorrichtung mittels des Schaltelements deaktivierbar ist, so dass im deaktivierten Zustand keine Fixierung eines in den Probenhalter eingeführten Probengläschens erfolgt.

Besonders bevorzugt ist eine Ausführungsform, bei der die Klemmvorrichtung einen Befestigungsring umfasst, der mit elastische Lamellen verbunden ist die wiederum an ihren Enden mit Klemmnippeln versehen sind, wobei die Klemmvorrichtung mittels des Befestigungsrings im Hohlraum des Probenhalters fixiert ist, und bei der die Klemmnippel der Klemmvorrichtung mittels des Schaltelements axial über innere konische Übertragungsflächen des Außenmantels verschiebbar sind, so dass eine radialen Auslenkung der Klemmnippel und somit eine Aktivierung der Klemmvorrichtung erzeugbar ist.

Für eine einfache Handhabung der Vorrichtung ist es vorteilhaft, wenn die Klemmvorrichtung vom oberen Rand des Probenhalters aus axial verschiebbar ist.

Bei einer bevorzugten Ausführungsform sind Übertragungsstifte vorgesehen, welche innerhalb des Hohlraums des Außenmantels angeordnet sind und die axiale Verschiebung des Schaltelements auf die Klemmvorrichtung übertragen.

Eine einfache aber besonders effektive Ausführungsform ergibt sich, wenn ein Federelement vorgesehen ist, welches zwischen einem unteren Absatz des Außenmantels und dem Befestigungsring der Klemmvorrichtung angeordnet ist und eine Kraft zum Aktivieren der Klemmvorrichtung aufbringt, wobei die vom Federelement auf den Befestigungsring aufgebrachte Kraft der Kraft, welche durch Betätigen des Schaltelements auf die Klemmvorrichtung wirkt, entgegen wirkt.

Das Federelement umfasst vorzugsweise einen Gummiring.

Um eine Unwucht während der Rotation des Probenhalters samt Probengläschen zu vermeiden, und um eine gleichmäßig auf das Probengläschen wirkende Klemmkraft zu realisieren ist es vorteilhaft, wenn die Bauelemente des Probenhalters jeweils symmetrisch um die Achse des Probenhalters angeordnet sind.

Bei einer besonders bevorzugten Ausführungsform ist der freie Innenraum der Klemmvorrichtung an den Außendurchmesser des Probengläschens angepasst. Besonders vorteilhaft ist es, wenn zudem der Innendurchmesser des Hohlraums an die neuen Abmessungen der abgeänderten Klemmvorrichtung angepasst ist. Auf diese Weise können ohne Beeinträchtigung der Haltekraft der Vorrichtung Probengläschen mit unterschiedlichen Außendurchmessern verwendet werden.

Vorzugsweise weist das Schaltelement an seinem unteren Ende einen Absatz auf, auf dem die Verschlusshülse des Probengläschens zum Aufliegen kommen kann.

Vorzugsweise ist der Probenhalter als Spinner oder als Shuttle ausgebildet.

Ein weiterer Aspekt der vorliegenden Erfindung ist die Realisierung einer kompakten automatischen Bestückungsvorrichtung für NMR-Apparaturen. Dies wird dadurch erreicht, dass die Bestückungsvorrichtung während des Bestückungsvorganges keinen Zugang zum unteren Bereich der Bestückungsvorrichtung benötigt. Eine solche Bestückungsvorrichtung besteht aus einem erfindungsgemäßen Probenhalter und einem Roboter zum Entnehmen eines Probengläschens aus einem Probenbehälter und zum Befördern, Einführen und Herausnehmen des Probegläschens in und aus dem Probenhalter, sowie einem Fixierer, innerhalb welchem der Probenhalter angeordnet und vom Fixierer fixierbar ist.

Da die Bestückungsvorrichtung während des Bestückungsvorganges keinen Zugang von unten benötigt, darf der Fixierer vorzugsweise direkt über einem Kryostaten der NMR-Apparatur am oberen Ende einer in einer Raumtemperaturbohrung der NMR-Apparatur angeordneten Dock-Unit montiert werden.

Bei einer besonders bevorzugten Ausführungsform der erfindungsgemäßen automatische Bestückungsvorrichtung umfasst der Fixierer erste Schieber als Anschlag für das Schaltelement und den Außenmantel des Probenhalters sowie erste pneumatische Zylinder, wobei die ersten Schieber mittels der ersten pneumatischen Zylinder in horizontaler Richtung verschiebbar sind. Somit ist ein einfacher Austausch des Probenhalters möglich.

Besonders vorteilhaft ist es, wenn der Fixierer zweite Schieber sowie zweite pneumatische Zylinder umfasst, wobei die zweiten Schieber mittels der zweiten pneumatischen Zylinder in horizontaler Richtung derart verschiebbar sind, dass bei einer Verschiebung der zweiten Schieber radial inwärts die zweiten Schieber äußere konische Flächen des Außenmantels des Probenhalters kontaktieren. Auf diese Weise kann der Probenhalter fixiert beziehungsweise freigegeben werden.

Bei einer speziellen Ausführungsform sind die pneumatischen Zylinder des Fixierers automatisch steuerbar.

Die Erfindung betrifft auch ein Verfahren zum Bestücken einer NMR-Apparatur mittels einer zuvor beschriebenen erfindungsgemäßen automatischen Bestückungsvorrichtung, wobei mittels des Roboters ein Probengläschen mit einer Messsubstanz aus einem Probenbehälter entnommen und in den Probenhalter derart eingeführt wird, dass die Achse des Probengläschens mit der Achse des Probenhalters übereinstimmt; wobei nach Positionieren des Probengläschens im Probenhalter die zweiten Schieber mittels der zweiten pneumatischer Zylinder in horizontaler Richtung radial nach außen verschoben werden, so dass der Kontakt der zweiten Schieber zu den äußeren konischen Flächen des Außenmantel des Probenhalters gelöst wird und sich der Probenhalter durch die Schwerkraft nach unten bewegt; und wobei das Federelement zwischen dem Außenmantel des Probenhalters und dem Befestigungsring der Klemmvorrichtung entlastet wird und die Klemmnippel durch die dabei auf die Klemmvorrichtung nach oben wirkende Kraft des Federelements gegen die inneren konischen Übertragungsflächen getrieben und radial nach innen ausgelenkt werden, so dass das Probengläschen in der Klemmvorrichtung fixiert wird.

Weitere Vorteile der Erfindung ergeben sich aus der Beschreibung und der Zeichnung. Ebenso können die vorstehend genannten und die weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:
- Figur 1: eine seitliche Schnittdarstellung eines erfindungsgemäßen Probenhalters mit aktivierter Klemmvorrichtung;
- Figur 2: den Probenhalter aus Figur 1 mit deaktivierter Klemmvorrichtung;
- Figur 3: eine Aufsicht sowie eine seitliche Schnittdarstellung eines erfindungsgemäßen Fixierers mit Probenhalter mit deaktivierter Klemmvorrichtung;
- Figur 4a-c: eine schematische Darstellungen des erfindungsgemäßen Verfahrens zur automatischen Bestückung einer NMR-Apparatur mittels einer erfindungsgemäßen Bestückungsvorrichtung, wobei ein Proben-gläschen ins Innere der NMR-Apparatur transportiert wird;
- Figur 5a-c: eine schematische Darstellungen des erfindungsgemäßen Verfahrens zur automatischen Bestückung einer NMR-Apparatur mittels einer erfindungsgemäßen Bestückungsvorrichtung, wobei ein Proben-gläschen aus dem Inneren der NMR-Apparatur transportiert wird.

Ziel der erfindungsgemäßen Vorrichtung ist die Realisierung einer Betriebsanlage für den automatisierten Wechsel von NMR-Probengläschen, die sehr kompakt aufgebaut ist und dadurch vollständig im oberen Bereich des Kryostaten montiert werden kann. Das Schlüsselelement zur Erreichung dieses Ziels ist ein speziell konstruierte Bestückungsautomat (= Bestücker), der während des Bestückungsvorganges keinen Zugriff des Roboters zum unteren Bereich des Bestückers benötigt. Dadurch ist es möglich, den Bestücker direkt über der RT-Bohrung des Kryostaten zu montieren, was zu einer enorm Platz sparenden Lösung führt.

Da auch der Roboter und der Probenbehälter wenig Platz beanspruchen, können auch diese über dem Kryostaten und nahe beim Bestücker montiert resp. positioniert werden. Auf diese Weise entsteht gesamthaft ein Kompaktes Bestückungssystem, das ohne großes Montagegestell auskommt.

Der Bestücker besteht aus einem Fixiertautomaten (= Fixierer), der ein einfaches Steuersystem besitzt, mit dem ein speziell konstruierter erfindungsgemäßer Probenhalter festgehalten oder losgelassen, und eine Klemmvorrichtung im Innern des Probenhalters ein- oder ausgeschaltet werden kann.

Der erfindungsgemäße Probenhalter kann als "Spinner" oder als "Shuttle" ausgeführt sein, und er besitzt je nach Durchmesser des Probengläschens und je nach Verwendungszweck, d.h. ob er als "Spinner" oder als "Shuttle funktionieren soll, innen verschiedene, außen jedoch vorzugsweise gleiche Abmessungen, so dass keine Kompatibilitätsprobleme mit der vorhandenen Dock-Unit und dem Probenkopf entstehen.

Der erfindungsgemäße Probenhalter besitzt in seinem Innern einen entlang seiner Rotationsachse verlaufenden durchgehenden Hohlraum, in welchem eine von außen ein- oder ausschaltbare mechanische Klemmvorrichtung untergebracht ist. Die Klemmvorrichtung erfüllt die Aufgabe, das Probengläschen entweder frei zu geben (deaktivierter Zustand) oder so präzise festzuhalten, dass die Achse des Probenhalters und die des Probengläschens möglichst genau übereinstimmen (aktivierter Zustand).

Das Ein- oder Ausschalten der Klemmvorrichtung geschieht mit Hilfe eines Schaltelementes 6, das sich im Hohlraum des Probenhalters befindet, von außen axial verschiebbar ist, vom oberen Rand des Probenhalters aus betätigt werden kann, und die axiale Verschiebung auf die Klemmvorrichtung überträgt. Die Klemmvorrichtung ihrerseits transformiert die axiale Verschiebung mit Hilfe von konischen Übertragungsflächen 5 in eine radiale Verschiebung seiner Klemmnippel 9c, wodurch das Probengläschen festgehalten oder wieder losgelassen wird.

Die Übertragung der axialen Verschiebung des Schaltelementes 6 auf die Klemmvorrichtung kann vorzugsweise über mehrere Übertragungsstifte 8a, 8e erfolgen, welche mit Hilfe von axialen Bohrungen durch die obere konische Fläche 5, die Verbindung zur Klemmvorrichtung herstellen.

Die Kraft, welche die Klemmvorrichtung zum Halten des Probengläschens aufbringen muss, kann vorzugsweise von einem Federelement 10 geliefert werden, das vorzugsweise aus einem Gummiring besteht.

Alle zum Probenhalter zugehörigen Bauelemente besitzen entweder eine gemeinsame Symmetrieachse, die mit der Rotationsachse des Probenhalters übereinstimmt, oder wenn es sich um Gruppen von Bauelementen handelt (z.B. die Übertragungsstifte 8a, 8e, sind die einzelnen Bauelemente symmetrisch und gleichmäßig um die Rotationsachse des Probenhalters angeordnet.

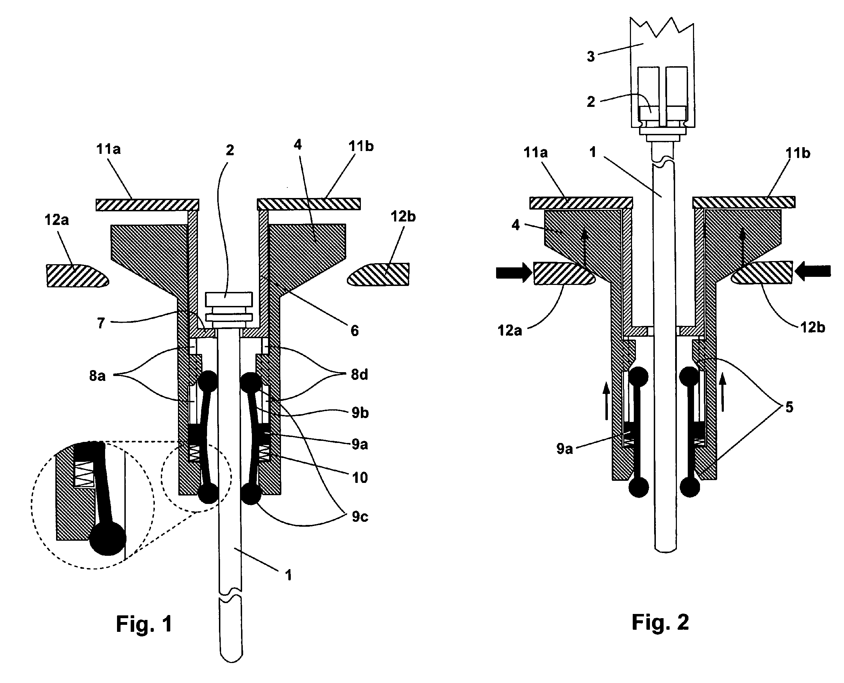

Eine bevorzugte Ausführungsform des Probenhalters ist in Fig. 1 und Fig. 2 dargestellt. Fig. 1 zeigt den Probenhalter mit eingeschalteter und Fig. 2 mit ausgeschalteter Klemmvorrichtung. Die wesentlichsten Bestandteile des Probenhalters sind:
1. Außenmantel 4 , der in seinem inneren Hohlraum zwei konische Flächen 5 besitzt.
2. Klemmvorrichtung bestehend aus Befestigungsring 9a, elastische Lamellen 9b und Nippel 9c, die sich an den beiden Enden der Lamellen 9b befinden. Beim Einschalten der Klemmvorrichtung verklemmen sich diese Nippel zwischen Probengläschen und Außenmantel 4 und erzeugen dadurch eine feste Verbindung zwischen diesen beiden Teilen.
3. Schaltelement 6 , das am unteren Ende einen Absatz 7 aufweist. Dieser definiert mit Hilfe der Verschlusshülse 2 die Position des Probengläschens innerhalb des Probenhalters und verhindert zudem, dass das Probengläschen aus dem Probenhalter fallen kann.
4. Übertragungsstifte 8a, 8e, welche die Aufgabe haben, die axiale Verschiebung des Schaltelementes 6 gegenüber dem Außenmantel 4 auf den Befestigungsring 9a zu übertragen, so dass der Befestigungsring 9a sich stets synchron mit dem Schaltelement 6 in axialer Richtung bewegt.
5. Federelement 10 , das bei eingeschalteter Klemmvorrichtung die notwendige Kraft erzeugen muss, um das Probengläschen einzuklemmen.

Zum Einschalten der Klemmvorrichtung (Fig. 1) wird das Schaltelement 6 entlastet, d.h. es soll keine äußere Kraft darauf wirken, so dass die Federwirkung des Federelementes 10 den Befestigungsring 9a nach oben drückt. Dadurch werden die Nippel 9c zwischen die konischen Flächen 5 und dem Probengläschen gedrückt und erzeugen dadurch die erwünschte feste Verbindung zwischen dem Probengläschen und dem Außenmantel 4.

Zum Ausschalten der Klemmvorrichtung wird das Schaltelement 6 nach unten in den Außenmantel 4 gedrückt. Die Übertragungsstifte 8a bis und mit 8e übertragen diese Bewegung auf den Befestigungsring 9, der dadurch nach unten gedrückt wird und die Nippel 9c von den konischen Flächen 5 entfernt. Der Kontakt zwischen Probengläschen und Außenmantel 4 wird dadurch aufgehoben und das Probengläschen wieder frei gegeben.

Fig. 2 zeigt den bevorzugten Vorgang zum Ausschalten der Klemmvorrichtung. Er entspricht genau dem oben geschilderten Vorgang, wenn die Bewegungen der Einzelteile relativ zueinander betrachtet werden. In Fig. 2 wird das Schaltelement 6 samt den Übertragungsstiften 8a, 8e und dem Befestigungsring 9 in einer konstanten Position gehalten, und nur der Außenmantel 4 mit Hilfe der Schieber 12a und 12b nach oben gedrückt. Dadurch werden die konischen Flächen 5 von den Nippeln 9c entfernt, der Kontakt zwischen Probengläschen und Außenmantel 4 aufgehoben und das Probengläschen wieder frei gegeben.

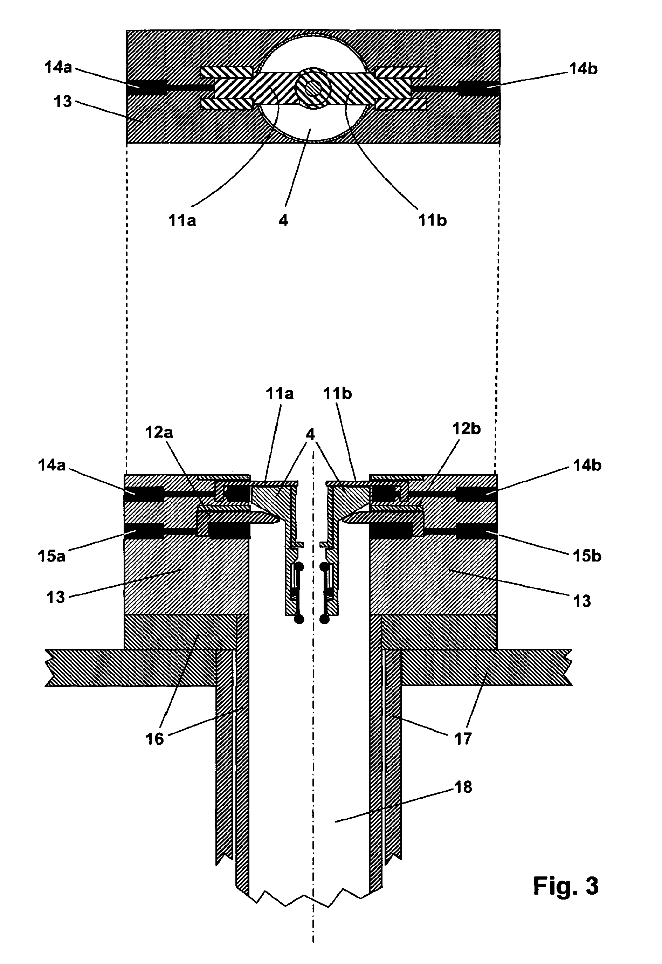

Eine bevorzugte Ausführungsform des erfindungsgemäßen Fixierers ist in Fig. 3 dargestellt. Zwei pneumatische Zylinder 14a und 14b betätigen zwei Schieber 11a und 11 b, welche den Anschlag für das Schaltelement 6 und den Außenmantel 4 definieren. Diese beiden Schieber befinden sich normalerweise im herausgefahrenen Zustand und werden nur dann wieder zurückgefahren, wenn der Probenhalter ausgewechselt werden muss (z.B. beim Wechsel vom "Spinner" zum "Shuttle" oder wenn ein anderer Durchmesser des Probengläschens gewünscht wird).

Die beiden pneumatischen Zylinder 15a und 15b betätigen die beiden Schieber 12a und 12b, mit denen der Außenmantel 4 mit Hilfe seiner außen liegenden konischen Fläche an die beiden Schieber 11 a und 11 b gepresst wird.

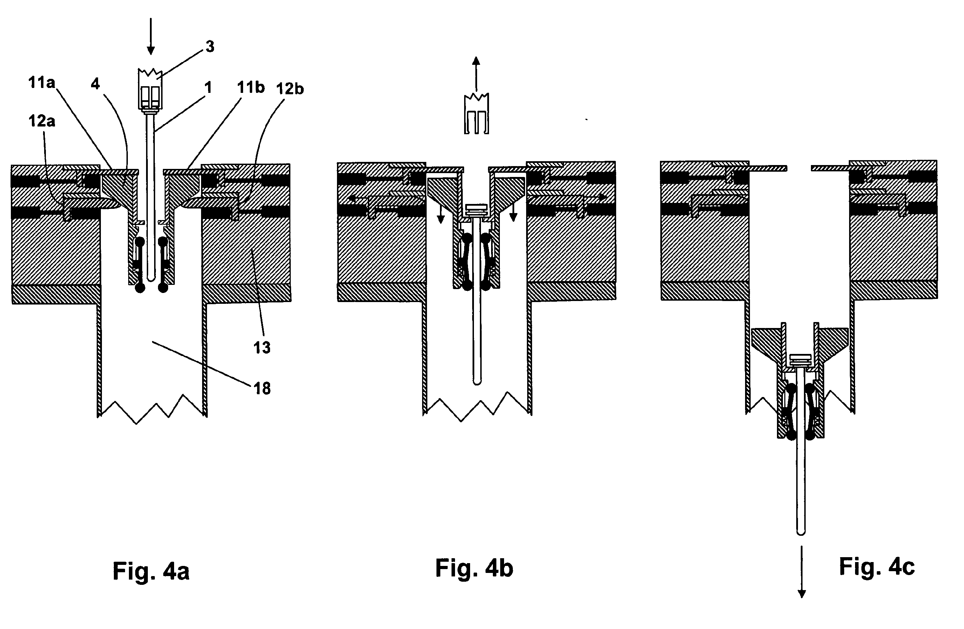

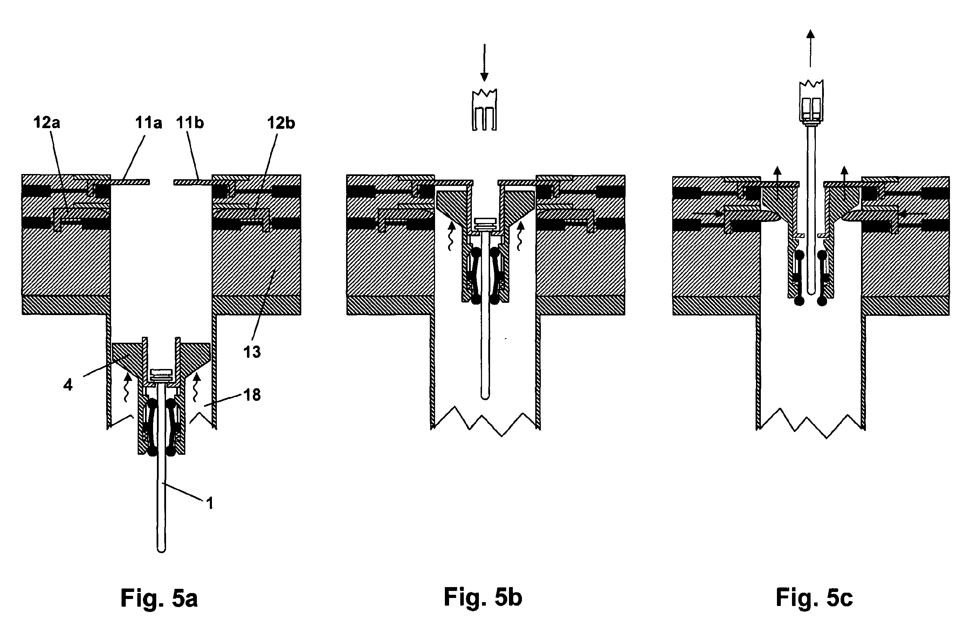

Nachfolgend soll der Bestückungs- und Entnahmevorgang in Einzelschritten beschrieben werden.
1. Anfangszustand: Im Fixierer befindet sich der leere Probenhalter, der durch die beiden herausgefahrenen Schieber 12a und 12b festgehalten wird. Die Klemmvorrichtung ist dadurch deaktiviert.
2. Der Luftkissenautomat wird aktiviert, d.h. die Pressluft wird eingeschaltet.
3. Der Roboter fasst mit Hilfe einer Greifzange 3 ein Probengläschen aus einem Probenbehälter, transportiert dieses zum Fixierer, und führt es dort von oben in den Probenhalter hinein, bis es die gewünschte Position erreicht hat (Fig. 4a).
4. Der Fixierer fährt die beiden Schieber 12a und 12b zurück, wodurch der Außenmantel mit Hilfe des Federelementes 10 nach unten gedrückt, die Klemmvorrichtung eingeschaltet, und das Probengläschen festgehalten wird (Fig. 4b). Von jetzt an werden Probengläschen und Probenhalter beide vom Roboter gehalten und getragen.
5. Der Roboter löst die Greifzange 3, so dass der Probenhalter samt Probengläschen nur noch vom Luftkissen des Luftkissenautomaten getragen wird (Fig. 4b).
6. Der Probenhalter samt Probengläschen wird vom Luftkissenautomaten hinunter in den Messraum befördert (Fig. 4c), wo er auf dem Stator der Luftturbine des Probenkopfes zu liegen kommt.
7. Der Luftkissenautomat wird deaktiviert, d.h. die Pressluft wird ausgeschaltet, und der Messvorgang kann jetzt gestartet werden.
   Nach dem Messvorgang folgt der Entnahmevorgang.
8. Der Luftkissenautomat wird wieder aktiviert, d.h. die Pressluft wieder eingeschaltet.
9. Mit Hilfe des Luftkissenautomaten wird der Probenhalter samt Probengläschen wieder zurück zum Fixierer befördert (Fig. 5a), wo er durch die beiden Schieber 11a und 11 b am oberen Ende des Fixierers gestoppt und durch den Luftdruck des Luftkissenautomaten in dieser Position gehalten wird (Fig. 5b).
10. Der Roboter fasst mit Hilfe der Greifzange 3 das Probengläschen, ohne jedoch dessen Position zu ändern (Fig. 5b).
11. Der Fixierer fährt die beiden Schieber 12a und 12 wieder heraus und schaltet damit die Klemmvorrichtung wieder aus (Fig. 5c). Das Probengläschen wird jetzt nur noch vom Roboter gehalten und getragen.
12. Der Roboter führt das Probengläschen aus dem Probenhalter heraus (Fig. 5c) und befördert es wieder zurück zum Probenbehälter.
13.Anschließend geht es mit Punkt 3 weiter.

Die erfinderische Vorrichtung unterscheidet sich vom Stand der Technik in folgenden Punkten:
- Der erfindungsgemäße Probenhalter enthält in seinem Innern eine Klemmvorrichtung, die auf das Probengläschen wirkt und automatisch ein- oder ausgeschaltet werden kann.
- Der erfindungsgemäße Fixierer hat neben der Aufgabe, den Probenhalter zu fixieren, auch noch die Aufgabe, die Klemmvorrichtung des erfindungsgemäßen Probenhalters ein- oder auszuschalten.
- Da bei der erfindungsgemäßen Bestückungsvorrichtung eine automatische Klemmvorrichtung im Probenhalter vorhanden ist, benötigt der Roboter keinen Zugang mehr zum unteren Bereich des Bestückers und kann deshalb direkt über dem Kryostaten am oberen Ende der Dock-Unit montiert werden.
- Der erfindungsgemäße Probenhalter ist so konstruiert, dass der obere Teil des Probengläschens im erfindungsgemäßen Probenhalter versenkt werden kann, so dass die Verwendung von kurzen Probengläschen mit einer Länge von vorzugsweise 100 bis 120 mm möglich ist.
- Bei der erfindungsgemäßen Bestückungsvorrichtung können alle Elemente direkt auf dem Kryostaten des supraleitenden NMR-Magneten montiert werden.

### Bezugszeichenliste

- 1: Probengläschen
- 2: Verschlusshülse des Probengläschens 1
- 3: Greifzange zum Festhalten der Verschlusshülse 2
- 4: Außenmantel des Probenhalters
- 5: Konische Flächen im inneren Hohlraum des Probenhalters
- 6: Schaltelement, das vom oberen Rand des Probenhalters aus betätigt werden kann und zum Ein- und Ausschalten der Klemmvorrichtung 9a, 9b, 9c dient
- 7: Absatz am unteren Rand des Schaltelementes, der als Anschlag für die Verschlusshülse 2 dient und ein Hinunterfallen des Probengläschens verhindert
- 8a, 8e: Übertragungsstifte (vorzugsweise 6 Stück gleichmäßig über den Umfang verteilt), welche zur Übertragung der axialen Verschiebung des Schaltelementes 6 auf den Befestigungsring 9a der Klemmvorrichtung dienen
- 9a: Befestigungsring, der die Lamellen 9b zusammenhält
- 9b: Elastische Lamellen der Klemmvorrichtung (vorzugsweise 9 Stück gleichmäßig über den Umfang verteilt)
- 9c: Nippel, die an den beiden Enden der elastischen Lamellen 9b angebracht sind
- 10: Federelement, vorzugsweise aus einem Gummiring bestehend
- 11 a, 11 b: erste Schieber, die zuoberst am Fixierer angebracht sind und als Anschlag für den Außenmantel 4 und das Schaltelement 6 dienen
- 12a, 12b: zweite Schieber, die innerhalb des Fixierers angebracht sind und zum Ein- und Ausschalten der Klemmvorrichtung verwendet werden
- 13: Fixierer
- 14a, 14b: erste pneumatische Zylinder, mit denen die Schieber 11a und 11b betätigt werden
- 15a, 15b: zweite pneumatische Zylinder, mit denen die Schieber 12a und 12b betätigt werden
- 16: Dock-Unit
- 17: Kryostat, der den supraleitenden NMR-Magneten enthält
- 18: Zylindrischer Schacht, durch welchen der Probenhalter samt Probengläschen auf einem Luftkissen in den Messraum befördert wird

## Patentansprüche

1. Probenhalter zum Fixieren und Transportieren eines Probengläschens (1) innerhalb einer Kernspinresonanz(=NMR)-Anordnung mit einem Außenmantel (4) und einem innerhalb des Außenmantels (4) angeordneten, entlang seiner Achse verlaufenden durchgehenden Hohlraum zum Aufnehmen des Probengläschens,
**dadurch gekennzeichnet,**
**dass** eine lösbare Klemmvorrichtung und ein Schaltelement (6) innerhalb des Hohlraum vorgesehen sind, wobei die Klemmvorrichtung im aktivierten Zustand ein in den Probenhalter eingeführtes Probengläschen (1) fixiert, dass das Schaltelement (6) von außen betätigbar ist,
und **dass** die Klemmvorrichtung mittels des Schaltelements (6) deaktivierbar ist, so dass im deaktivierten Zustand keine Fixierung eines in den Probenhalter eingeführten Probengläschens (1) erfolgt.

2. Probenhalter nach Anspruch 1, **dadurch gekennzeichnet, dass** die Klemmvorrichtung einen Befestigungsring (9a) umfasst, der mit elastische Lamellen (9b) verbunden ist die wiederum an ihren Enden mit Klemmnippeln (9c) versehen sind, wobei die Klemmvorrichtung mittels des Befestigungsrings (9a) im Hohlraum des Probenhalters fixiert ist, und
dass die Klemmnippel (9c) der Klemmvorrichtung mittels des Schaltelements (6) axial über innere konische Übertragungsflächen (5) des Außenmantels (4) verschiebbar sind, so dass eine radialen Auslenkung der Klemmnippel (9c) und somit eine Aktivierung der Klemmvorrichtung erzeugbar ist.

3. Probenhalter nach einem der vorhergehenden Ansprüche, **dadurch gekennzeichnet, dass** die Klemmvorrichtung vom oberen Rand des Probenhalters aus axial verschiebbar ist.

4. Probenhalter nach Anspruch 3, **dadurch gekennzeichnet, dass** Übertragungsstifte (8a, 8d) vorgesehen sind, welche innerhalb des Hohlraums des Außenmantels (4) angeordnet sind und die axiale Verschiebung des Schaltelements (6) auf die Klemmvorrichtung übertragen.

5. Probenhalter nach einem der vorhergehenden Ansprüche, **dadurch gekennzeichnet, dass** ein Federelement (10) vorgesehen ist, welches zwischen einem unteren Absatz des Außenmantels und dem Befestigungsring (9a) der Klemmvorrichtung angeordnet ist und eine Kraft zum Aktivieren der Klemmvorrichtung aufbringt, wobei die vom Federelement (10) auf den Befestigungsring (9a) aufgebrachte Kraft der Kraft, welche durch Betätigen des Schaltelements (6) auf die Klemmvorrichtung wirkt, entgegen wirkt.

6. Probenhalter nach einem der vorhergehenden Ansprüche, **dadurch gekennzeichnet, dass** das Federelement (10) einen Gummiring umfasst.

7. Probenhalter nach einem der vorhergehenden Ansprüche, **dadurch gekennzeichnet, dass** die Bauelemente des Probenhalters jeweils symmetrisch um die Achse des Probenhalters angeordnet sind.

8. Probenhalter nach einem der vorhergehenden Ansprüche, **dadurch gekennzeichnet, dass** der freie Innenraum der Klemmvorrichtung an den Außendurchmesser des Probengläschens angepasst ist.

9. Probenhalter nach einem der vorhergehenden Ansprüche, **dadurch gekennzeichnet, dass** das Schaltelement (6) an seinem unteren Ende einen Absatz (7) aufweist.

10. Probenhalter nach einem der vorhergehenden Ansprüche, **dadurch gekennzeichnet, dass** der Probenhalter als Spinner oder als Shuttle ausgebildet ist.

11. Automatische Bestückungsvorrichtung für NMR-Apparaturen mit
einem Probenhalter nach einem der vorhergehenden Ansprüche,
einem Roboter zum Entnehmen eines Probengläschens (1) aus einem Probenbehälter und zum Befördern, Einführen und Herausnehmen des Probegläschens (1) in und aus dem Probenhalter, und mit
einem Fixierer (13) innerhalb welchem der Probenhalter angeordnet und vom Fixierer fixierbar ist.

12. Automatische Bestückungsvorrichtung nach Anspruch 11, **dadurch gekennzeichnet, dass** der Fixierer (13) direkt über einem Kryostaten der NMR-Apparatur am oberen Ende einer in einer Raumtemperaturbohrung der NMR-Apparatur angeordneten Dock-Unit (16) montiert ist.

13. Automatische Bestückungsvorrichtung nach einem der Ansprüche 11 oder 12, **dadurch gekennzeichnet, dass** der Fixierer (13) erste Schieber (11a, 11 b) als Anschlag für das Schaltelement (6) und den Außenmantel (4) des Probenhalters sowie erste pneumatische Zylinder (14a, 14b) umfasst, wobei die ersten Schieber (11 a, 11 b) mittels der ersten pneumatischen Zylinder (14a, 14b) in horizontaler Richtung verschiebbar sind.

14. Automatische Bestückungsvorrichtung nach einem der Ansprüche 11 bis 13, **dadurch gekennzeichnet, dass** der Fixierer (13) zweite Schieber (12a, 12b) sowie zweite pneumatische Zylinder (15a, 15b) umfasst, wobei die zweiten Schieber (12a, 12b) mittels der zweiten pneumatischen Zylinder (15a, 15b) in horizontaler Richtung derart verschiebbar sind, dass bei einer Verschiebung der zweiten Schieber (12a, 12b) radial inwärts die zweiten Schieber äußere konische Flächen des Außenmantels (4) des Probenhalters kontaktieren.

15. Automatische Bestückungsvorrichtung nach einem der Ansprüche 13 oder 14, **dadurch gekennzeichnet, dass** die pneumatischen Zylinder (14a, 14b, 15a, 15b) des Fixierers (13) automatisch steuerbar sind.

16. Verfahren zum Bestücken einer NMR-Apparatur mittels einer automatischen Bestückungsvorrichtung nach einem der Ansprüche 11 bis 15
wobei mittels des Roboters ein Probengläschen (1) mit einer Messsubstanz aus einem Probenbehälter entnommen und in den Probenhalter derart eingeführt wird, dass die Achse des Probengläschens mit der Achse des Probenhalters übereinstimmt;
wobei nach Positionieren des Probengläschens (1) im Probenhalter die zweiten Schieber (12a, 12b) mittels der zweiten pneumatischer Zylinder (15a, 15b) in horizontaler Richtung radial nach außen verschoben werden, so dass der Kontakt der zweiten Schieber (12a, 12b) zu den äußeren konischen Flächen des Außenmantel des Probenhalters gelöst wird und sich der Probenhalter durch die Schwerkraft nach unten bewegt; und
wobei das Federelement (10) zwischen dem Außenmantel (4) des Probenhalters und dem Befestigungsring (9a) der Klemmvorrichtung entlastet wird und die Klemmnippel (9c) durch die dabei auf die Klemmvorrichtung nach oben wirkende Kraft des Federelements (10) gegen die inneren konischen Übertragungsflächen (5) getrieben und radial nach innen ausgelenkt werden, so dass das Probengläschen (1) in der Klemmvorrichtung fixiert wird.
